# EUROPEAN PATENT SPECIFICATION

(11) **EP 2 308 148 B1**
(45) Date of publication and mention of the grant of the patent: **29.10.2014**
(21) Application number: 09769644.7
(22) Date of filing: 24.06.2009
(51) Int. Cl.: H02J 9/00, H03K 3/28, H03K 5/12, H03K 17/68

(54) **STANDBY CIRCUIT AND ELECTRIC APPLIANCE COMPRISING SUCH A CIRCUIT**
STANDBY-SCHALTUNG UND ELEKTRISCHES GERÄT MIT EINER SOLCHEN SCHALTUNG
CIRCUIT DE VEILLE ET APPAREIL ÉLECTRIQUE COMPRENANT CELUI-CI

(30) Priority: 27.06.2008 IT TO20080506
(43) Date of publication of application: 13.04.2011
(73) Proprietor: Indesit Company, S.p.A., 60044 Fabriano (AN) (IT)
(72) Inventor: TORDONI, Simone, I-06034 Foligno (PG) (IT); POSSANZA, Mauro, I-60044 Fabriano (AN) (IT); CORSI, Fabrizio, I-67018 Sassa l'Aquila (AQ) (IT); CESARONI, Andrea, I-60035 Jesi (AN) (IT)
(74) Representative: Santonicola, Paolo
(86) International application number: PCT/IB2009/006046
(87) International publication number: WO 2009/156831

(56) References cited:
- EP-A2- 0 800 955
- EP-A2- 1 069 667
- US-A- 4 413 290

## Description

The present invention relates to a standby circuit according to the preamble of claim 1. The invention also relates to an electric appliance comprising such a circuit.

Many electric appliances, in particular household appliances, are supplied with domestic mains alternating voltage, typically 230V at 50Hz or 110V at 60Hz.

The connection to the domestic mains is provided by means of an AC/DC power supply outputting a direct voltage (e.g. 12V) intended for some electronic modules, such as the control unit or the user interface panel of the electric appliance.

When an electric appliance is not in operation, it is placed into a standby state providing a lower energy consumption.

In order to achieve the desired reduction in energy consumption, some known electric appliances have a switch at the power supply output which can break the line carrying direct voltage. When the electric appliance is placed in the standby state, the control unit opens the switch and all the electric units connected to the direct voltage are turned off.

The switch will then be reset when the user manually presses a button.

Although effective, these solutions are costly; it would therefore be appropriate to find out low-cost alternative solutions requiring fewer components.

Document EP1069667-A2 discloses a low power consumption type automobile-mounted controller capable of switching so as not to continue power consumption of the automobile-mounted power source when the automobile has not been used over a long term. The low power consumption type automobile-mounted controller is provided with a microcontroller unit having a power supply port, a voltage detection port, a control port, a communication port, and an input port; a first power supply path connected to the automobile-mounted power source through a change-over switch for turning ON/Off the power supply port; a second power supply path for connecting the power supply port to the automobile-mounted power source through a controllable switch; and power open/ close command means for turning ON/OFF the controllable switch in response to a power close command signal or a power open command signal, and operates in such a manner that on receipt of the power open command signal while the first power supply path is intercepted by turning OFF the change-over switch, the power open/close command means turns OFF the controllable switch to intercept the second power supply path.

Document US4413290 discloses a tape recorder with a voice signal responsive circuit. In the tape recorder, an auto-off circuit detects whether tape is being advanced and produces a stop signal when the tape has reached its end. A switching arrangement responds to the stop signal to turn off the recording apparatus including the motor. A voice signal responsive circuit produces a go signal which causes the switching arrangement to turn on the recording apparatus in response to a voice signal and causes the switching arrangement to turn the apparatus off in the absence of a voice signal. A selector arrangement switches the switching arrangement so it operates either in response to the auto-off circuit or in response to the voice signal responsive circuit.

The present invention aims at providing an alternative solution for a standby circuit.

This and other objects of the present invention are achieved through a standby circuit according to claim 1 and a household appliance incorporating the features set out in the appended claims.

The present invention is based on the idea of using a bistable circuit controlling a switch, in particular a transistor in pass-gate configuration, connected between a first terminal, which is to receive direct voltage from the power supply, and a second terminal, which is to supply direct voltage to the electronic modules downstream of the circuit.

The bistable circuit comprises two transistors, in particular two BJTs, one having the collector connected to the base of the other through a resistor (R39).

The first transistor is of the p type and the emitter thereof is connected to the mains voltage.

The second transistor is of the n type and it is in grounded emitter configuration, so that it supplies the collector with a drive voltage for driving the switch.

The collector of the second transistor is then connected to the base of the first transistor through a resistive and capacitive network (R40, R39, C6).

A standby circuit thus provided uses a very small number of low-cost components (since it requires no power devices) and represents a very good alternative to the existing circuits.

In order to stabilize the circuit, a polarization resistor is preferably placed between the base and the emitter of each transistor.

Advantageously, a feedback branch is also provided between the output terminal and the collector of the first transistor; said branch advantageously consists of a diode with the anode connected to the output terminal and the cathode connected to the collector of the first transistor.

Further objects and advantages of the present invention will become apparent from the following description and from the annexed drawings, which are supplied by way of nonlimiting example, wherein:
Fig. 1 diagrammatically shows the electronic architecture of an electric appliance according to the present invention,
Fig. 2 shows a standby circuit according to a first embodiment of the present invention,
Fig. 3 shows a standby circuit according to a second embodiment of the present invention,
Fig. 4 diagrammatically shows the electronic architecture of an electric appliance which is alternative to the one of Fig. 1.

In the present description, the same reference numerals or names will be used for designating identical or equivalent means. It should also be stated beforehand that all values mentioned below in regard to the properties of the various components (e.g. capacity of capacitors, resistance of resistors, etc.) are only provided in order to illustrate particular embodiments of the present invention and should not therefore be interpreted as limitations of the present invention.

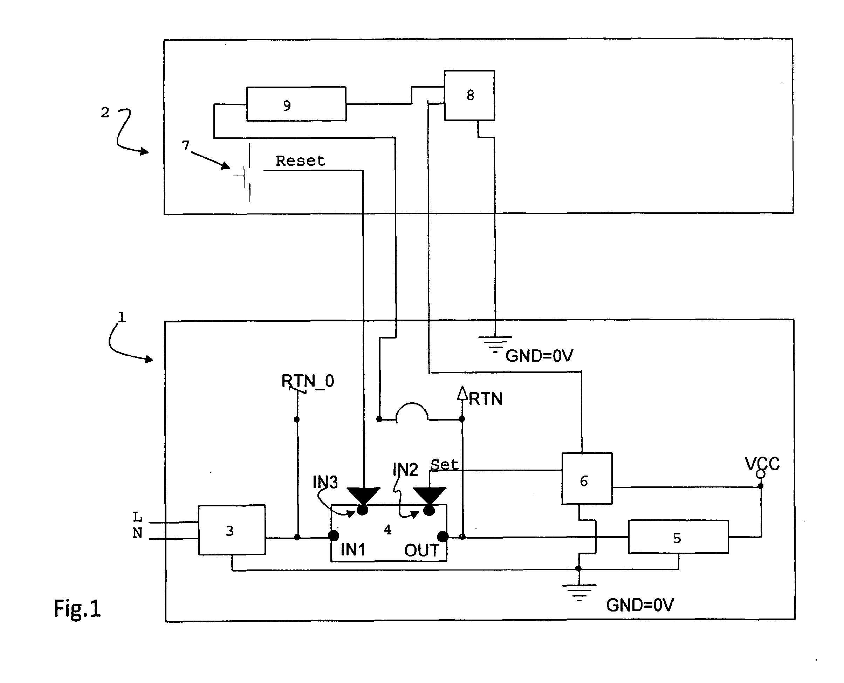

Referring now to Fig. 1, there is shown the electronic architecture of an electric appliance, in particular a household appliance such as a washing machine, an oven or a refrigerator. The electric appliance comprises a main board 1 and a user interface board 2 connected thereto.

Main board 1 houses an AC/DC power supply 3, preferably of the switching type, which receives the mains alternating voltage (through terminals L and N, to which the line and neutral wires of the domestic mains are connected) and converts it into a direct voltage RTN_0, e.g. 12V.

A standby circuit 4 connected to the output of power supply 3 allows to connect and disconnect line RTN to/from direct voltage RTN_0.

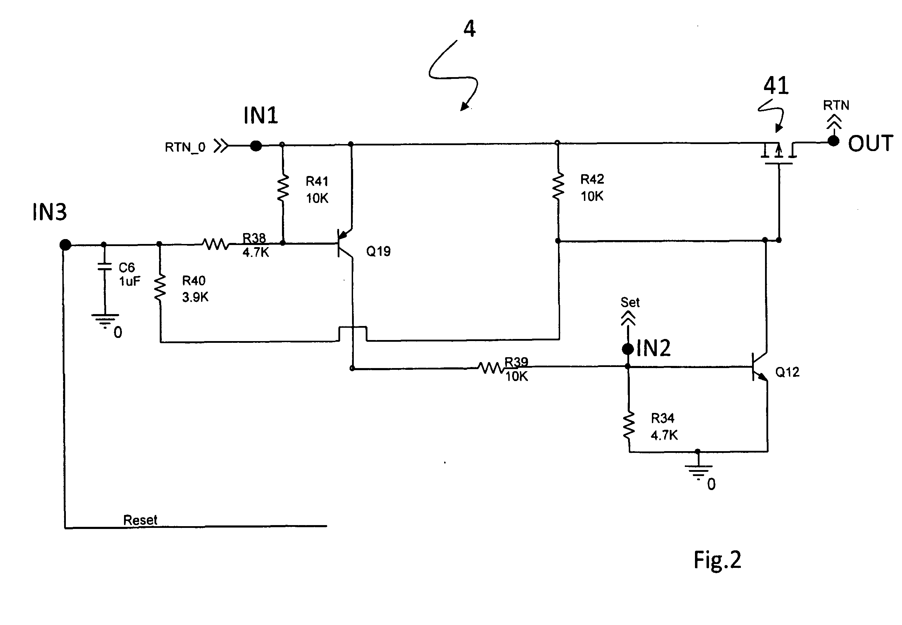

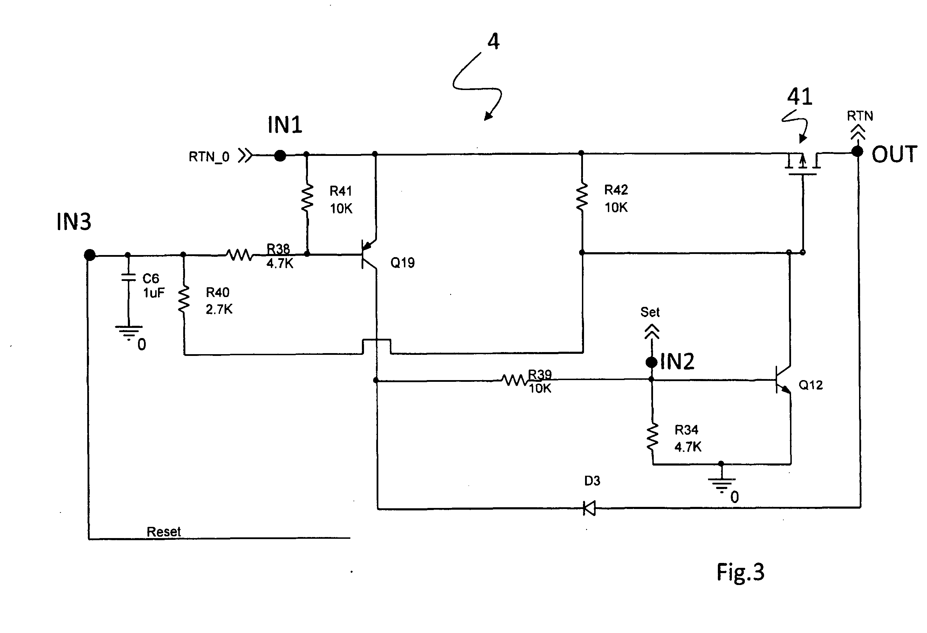

Further details of the standby circuit will be described below with reference to Figs. 2 and 3.

The main board also comprises a voltage regulator 5 which allows to stabilize the direct voltage outputted by the power supply.

The voltage thus stabilized (Vcc) powers microcontroller 6, whose task is to handle the loads, the actuators and the sensors (not shown) used for ensuring the correct operation of the electric appliance.

Microcontroller 6 is also used for controlling the standby state of the electric appliance; this is achieved by sending a suitable standby signal to the standby circuit. When it receives the standby signal, circuit 4 reacts by breaking the connection between RTN_0 and RTN, so that microcontroller 6, user interface board 2 and all the electronic modules powered by the stabilized direct voltage Vcc are switched off. In the example shown in Fig. 1, user interface board 2 is powered by direct voltage taken downstream of standby circuit 4.

For the appliance to exit the standby state, the user has to press a button 7, the mechanical action of which grounds the "Reset" line, thus manually resetting the standby circuit, which will then connect RTN_0 to RTN again.

Along with other control devices (such as buttons and knobs) and other signalling devices (such as LEDs and displays of various kinds), button 7 is one of those control means which are operated by the user for setting the operating parameters of the electric appliance.

With reference to a washing machine, such control means may, for example, be knobs through which the user can select the wash cycle or the type of laundry to be washed.

Said control means are afferent to the user interface board, where microcontroller 8 (supplied with RTN stabilized by regulator 9) interprets the user's commands, and then on the one hand it transfers the commands about the program to be executed by the electric appliance to microcontroller 6, while on the other hand it creates the man-machine interface, e.g. by displaying useful information on the display in response to a key being pressed or a knob being turned.

Fig. 2 shows the electric diagram of a standby circuit according to an embodiment of the present invention.

The standby circuit has three inputs (IN1, IN2 and IN3) and one output (OUT).

Input IN1 is to receive the direct voltage outputted by power supply 3.

Input IN2 is to receive the standby command from microcontroller 6.

Input IN3 is to receive the standby reset command from button 7.

Output OUT is to be connected to line RTN which, as explained above, carries direct voltage to some electronic modules of the electric appliance.

The core of standby circuit 4 is mosfet 41.

Mosfet 41 is in pass-gate configuration, with the source and drain connected to input IN1 (i.e. to voltage RTN_0) and to output OUT, respectively. It follows that mosfet 41 operates as a switch that, when closed (conducting mosfet), connects input IN1 to output OUT, whereas in the open position (interdicted mosfet) it leaves output OUT floating.

In order to control the switch, i.e. mosfet 41, a bistable circuit is used in which the transition between the two stable states is made possible by control signals sent over the "Reset" and "Set" lines afferent to inputs IN3 and IN2, respectively.

The bistable circuit comprises a first BJT transistor Q19 of the pnp type (e.g. the BC557B transistor by Motorola), and a second BJT transistor Q12 of the npn type (e.g. the BC547B transistor by Motorola).

Emitter of Q19 is connected to the direct voltage RTN_0, whereas the collector of Q19 is connected to the base of transistor Q12 through a 10KΩ resistor R39.

The collector of Q12 is connected to the gate of mosfet 41 and, through a 3.9KΩ resistor R40, to input IN3.

The base of transistor Q19 is connected to input IN3 through a 4.7KΩ resistor R38.

In parallel to the base-emitter and drain-source junctions of transistors Q12, Q19 and 41, suitable 10KΩ, 4.7KΩ and 10KΩ resistors (R41, R34 and R42, respectively) are arranged for polarizing the circuit.

A 1µF capacitor C6 connected across input IN3 and the ground performs the function of adjusting the time required for the electric appliance to exit the standby state.

When the electric appliance is connected to the domestic mains, capacitor C6 is initially discharged and Q19 conducts. As a consequence, Q12 will conduct as well, and mosfet 41 will become conducting; therefore, voltage RTN_0 present at input IN1 will be found at output OUT.

Through the effect of the feedback of R40, Q19 remains conducting and the bistable circuit enters a stable state wherein mosfet 41 conducts and a voltage equal to the input voltage (RTN_0) is found at output OUT.

In order to place the appliance into the standby state, the microcontroller forces input IN2 low by means of the "Set" line.

Q12 will thus be switched off, switching off mosfet 41 and transistor Q19 as well, and capacitor C6 will get charged.

The standby signal sent by microcontroller 6 then switches the bistable circuit to a second stable state wherein mosfet 41 is not conducting and the output RTN stays floating. When the electric appliance is to exit the standby state, a signal having a low logic value (e.g. 0V) is sent to input IN3 by pressing button 7.

This is obtained, for example, by having button 7 connect the "Reset" line to ground.

Capacitor C6 will discharge and Q19 will become conducting, thereby also making Q12 and mosfet 41 conducting, as previously explained: through feedback resistors R40 and R38, Q12 holds Q19 in the conducting state and the system will stay in a stable state even when button 7 is released.

The bistable circuit controlling switch 41 then enters that stable state in which the gate of mosfet 41 is kept just above the ground potential, and the mosfet 41 becomes conducting. In order to improve the stability of the bistable circuit, it is preferable to employ an additional feedback branch between output OUT and the collector of Q19, as shown by way of example in Fig. 3.

This additional feedback branch advantageously allows to keep Q12 in the conducting state even in the presence of electronic noise (e.g. the so called "burst noise" and "surge noise") interfering with the operation of the standby circuit.

According to this preferred solution, a diode D3 is connected with the anode to output OUT and with the cathode to the collector of Q19.

When circuit 4 is in the stable state with mosfet 41 in the conducting condition, D3 causes the base of Q12 to stay high and Q12 to remain conducting.

When D3 is added, feedback resistor R40 may have a lower value than in the solution lacking D3; in the example of Fig. 3, R40 is a 2.7kΩ resistor.

The advantages offered by the standby circuit according to the present invention and by an electric appliance comprising such a circuit are apparent from the above description.

It is clear however that the above-described examples only refer to exemplifying and preferred embodiments of the present invention, and that many changes may be made thereto by those skilled in the art without departing from the protection scope of the present invention as set out in the appended claims.

For example, it is clear that the transistors may without distinction be either BJTs or field-effect transistors, such as MOSFETs, and that the various components may be replaced with one or more equivalent circuits performing the same functions.

Likewise, mosfet 41 may be replaced with any other device or circuit capable of providing the function of a switch opening or closing depending on whether the drive signal is high or low.

It is also apparent that the standby circuit according to the present invention may also be used in electric appliances having an electronic architecture other than that shown in Fig. 1, i.e. wherever the supply of a direct voltage to an electric module must be interrupted in order to obtain a lower energy consumption.

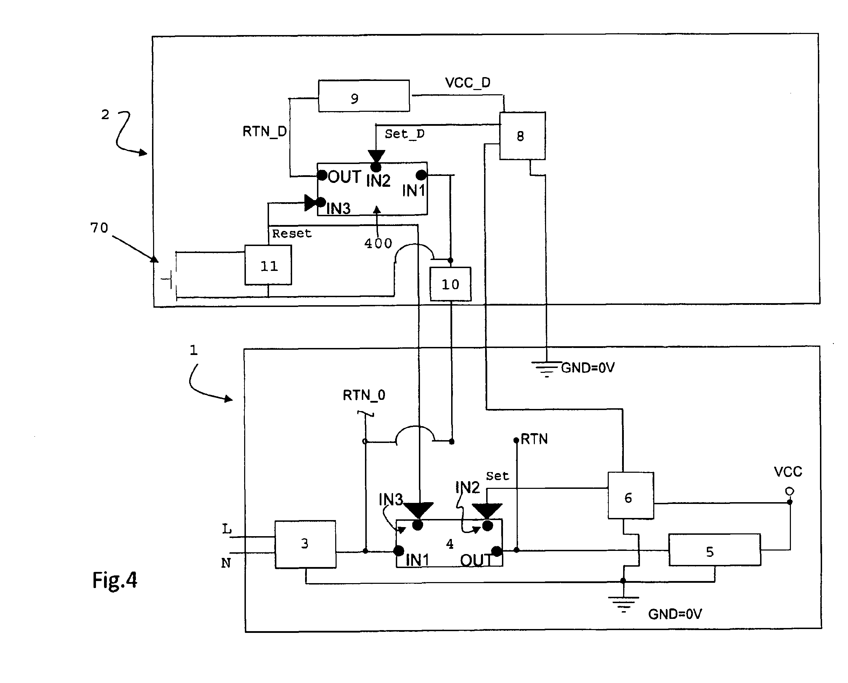

For example, Fig. 4 shows the architecture of an electric appliance employing a control panel fitted with buttons provided as touch sensors.

In the example of Fig. 4, user interface board 2 receives the voltage RTN_0 outputted by power supply 3 (taken upstream of standby circuit 4), so that an intervention of standby circuit 4 will not cut off the power to user interface board 2.

This measure is necessary because, unlike mechanical button 7 of Fig. 1, touch button 70 must be powered in order to be able to send the "Reset" signal that will remove the household appliance from the standby state.

In the example of Fig. 4, user interface board 2 may be provided with a voltage regulator 10 which allows voltage RTN_0 to be reduced from 12V to 5V or 3.3 V.

The voltage thus reduced will supply button 70 and microcontroller 11.

Microcontroller 11 has to interpret the output signal of button 70, i.e. to discern whether the user has pressed button 70 or not.

When microcontroller 11 detects that button 70 has been pressed, it will ground the Reset line, thereby switching the electric appliance from the standby state to the operating state. In order to still ensure a lower energy consumption in the standby state, the electric appliance of Fig. 4 comprises a second standby circuit 400, e.g. of the type shown in Fig. 2.

Standby circuit 400 is interposed between the output of regulator 10 and regulator 9 that supplies direct voltage Vcc_D to microcontroller 8.

When microcontroller 8 sends a Set_D command, corresponding to the "Set" command described above with reference to Fig. 1, circuit 400 will break the connection between regulator 9 and regulator 10, so that microcontroller 8 and the other electric modules possibly receiving the voltage outputted by regulator 9 will no longer be powered. When the user touches button 70 (which is always on), circuit 400 will receive the "Reset" signal from microcontroller 11 and will supply power to user interface board 2 again by connecting supply line RTN_D to the supply from main board 1.

## Claims

1. Electric standby circuit (4) for an electric appliance, comprising:
a switch (41) adapted to open and close an electric connection between a first input (IN1) and an output (OUT) of said circuit (4),
a bistable circuit electrically connected to said switch for controlling the opening and closing of said switch,
**characterized in that** said bistable circuit comprises
a first BJT transistor (Q19), and
a second BJT transistor (Q12), wherein
the emitter of the first transistor (Q19) is connected to said first input (IN1), and wherein
the collector of said first transistor (Q19) is connected to the base of the second transistor (Q12) through a first resistor (R39), and wherein
the collector of the second transistor (Q12) is connected to said switch (2) and to a second input (IN3) through a second resistor (R40), and wherein
the base of the first transistor (Q19) is connected to said second input (IN3) through a third resistor (R38).

2. Circuit according to claim 1, wherein said switch is a third transistor (41), and wherein the collector of said second transistor (Q12) is connected to a terminal of said third transistor.

3. Circuit according to claim 2, wherein said third transistor is a mosfet (41), the drain of the mosfet (41) being connected to said output, the source of the mosfet (41) being connected to said first input, and the gate of the mosfet (41) being connected to the collector of said second transistor (Q12).

4. Circuit according to claim 3, further comprising a resistor (R42) arranged in parallel to the drain-source junction of said mosfet (41).

5. Circuit according to any of the preceding claims, further comprising at least one resistor (R41, R34) arranged in parallel to one of the base-emitter junctions of said first and said second transistors.

6. Circuit according to any of the preceding claims, further comprising a capacitor (C6) connected across said second input (IN3) and the circuit ground.

7. Circuit according to any of the preceding claims, further comprising a third input (IN2) connected to the base of said second transistor (Q12) in order to receive a standby signal for said electric appliance.

8. Circuit according to any of the preceding claims, further comprising a feedback branch between the output (OUT) of said circuit and the collector of said first transistor (Q19).

9. Circuit according to any of the preceding claims, further comprising a diode (D3) connected with the anode to the output (OUT) of said circuit and with the cathode to the collector of said first transistor (Q19).

10. Electric appliance comprising
an AC/DC power supply (3) adapted to be connected to an alternating voltage line (L,N) and to convert said alternating voltage into a direct voltage (RTN_0),
a microcontroller (6) adapted to transmit a standby command,
a standby circuit (4) comprising a first input (IN1) connected to said power supply for receiving said direct voltage (RTN_0), an output (OUT) connected to a supply line (RTN), and a switch (41) interposed between said first input (IN1) and said output (OUT), **characterized in that** said standby circuit (4) is a circuit according to any of claims 1 to 9.

11. Appliance according to claim 10, wherein said microcontroller (8) is connected to said third input (IN2) in a manner such that it will ground said third input (IN2) when said electric appliance is to be placed into the standby state.

12. Appliance according to claim 11, further comprising a user interface board comprising at least one button (7,70) which can be operated by a user of said electric appliance, said button being connected to said second input (IN3) of said standby circuit (4) so that by pressing said button a signal is generated which grounds said second input (IN3).

13. Appliance according to claim 12, wherein said button is a touch button, and wherein a microcontroller (11) detects when said touch button is pressed and generates said signal adapted to ground said second standby input.

14. Appliance according to claim 12, wherein said user interface board comprises a second standby circuit (400) comprising a first input (IN1) connected to an output of said power supply for receiving a direct voltage, an output (OUT) connected to a second supply line (RTN_D) for supplying power to a second microcontroller (8), said second standby circuit (4) being a circuit according to any of claims 1 to 9.

15. Appliance according to claim 14, wherein said button (7, 70) is a touch button.

## Patentansprüche

1. Elektrische Standby-Schaltung (4) für ein elektrisches Gerät, umfassend:
einen Schalter (41), welcher dazu eingerichtet ist, eine elektrische Verbindung zwischen einem ersten Eingang (IN1) und einem Ausgang (OUT) der Schaltung (4) zu öffnen und zu schließen,
eine bistabile Schaltung, welche elektrisch mit dem Schalter verbunden ist, um das Öffnen und das Schließen des Schalters zu regeln/steuern,
**dadurch gekennzeichnet, dass** die bistabile Schaltung umfasst:
einen ersten BJT-Transistor (Q19), und
einen einen zweiten BJT-Transistor (Q12), wobei der Emitter des ersten Transistors (Q19) mit dem ersten Eingang (IN1) verbunden ist, und wobei der Kollektor des ersten Transistors (Q19) mit der Basis des zweiten Transistors (Q12) durch einen ersten Widerstand (R39) verbunden ist, und wobei der Kollektor des zweiten Transistors (Q12) mit dem Schalter (2) und einem zweiten Eingang (IN3) durch einen zweiten Widerstand (R40) verbunden ist, und wobei die Basis des ersten Transistors (Q19) mit dem zweiten Eingang (IN3) durch einen dritten Widerstand (R38) verbunden ist.

2. Schaltung nach Anspruch 1,
wobei der Schalter ein dritter Transistor (41) ist, und wobei der Kollektor des zweiten Transistors (Q12) mit einem Anschluss des dritten Transistors verbunden ist.

3. Schaltung nach Anspruch 2,
wobei der dritte Transistor ein MOSFET (41) ist, wobei der Drain des MOSFET (41) mit dem Ausgang verbunden ist, wobei die Source des MOSFET (41) mit dem ersten Eingang verbunden ist, und wobei das Gate des MOSFET (41) mit dem Kollektor des zweiten Transistors (Q12) verbunden ist.

4. Schaltung nach Anspruch 3,
ferner umfassend einen Widerstand (R42), welcher parallel zu dem Drain-Source-Übergang des MOSFET (41) angeordnet ist.

5. Schaltung nach einem der vorhergehenden Ansprüche,
ferner umfassend wenigstens einen Widerstand (R41, R34), welcher parallel zu einem der Basis-Emitter-Übergänge des ersten und zweiten Transistors angeordnet ist.

6. Schaltung nach einem der vorhergehenden Ansprüche,
ferner umfassend einen Kondensator (C6), welcher über den zweiten Eingang (IN3) und die Schaltungsmasse verbunden ist.

7. Schaltung nach einem der vorhergehenden Ansprüche,
ferner umfassend einen dritten Eingang (IN2), welcher mit der Basis des zweiten Transistors (Q12) verbunden ist, um ein Standby-Signal von dem elektrischen Gerät zu empfangen.

8. Schaltung nach einem der vorhergehenden Ansprüche,
ferner umfassend eine Rückkopplungsabzweigung zwischen dem Ausgang (OUT) der Schaltung und dem Kollektor des ersten Transistors (Q19).

9. Schaltung nach einem der vorhergehenden Ansprüche,
ferner umfassend eine Diode (D3), welche mit der Anode mit dem Ausgang (OUT) der Schaltung und mit der Kathode mit dem Kollektor des ersten Transistors (Q19) verbunden ist.

10. Elektrisches Gerät, umfassend:
eine AC/DC-Leistungszufuhr (3), welche dazu eingerichtet ist, mit einer Wechselspannungsleitung (L, N) verbunden zu werden, und die Wechselspannung in eine Gleichspannung (RTN_0) umzuwandeln,
einen Mikrocontroller (6), welcher dazu eingerichtet ist, einen Standby-Befehl zu übertragen,
eine Standby-Schaltung (4), umfassend einen ersten Eingang (IN1), welcher mit der Leistungszufuhr zum Empfangen der Gleichspannung (RTN_0) verbunden ist, einen Ausgang (OUT), welcher mit einer Zufuhrleitung (RTN) verbunden ist, und einen Schalter (41), welcher zwischen dem ersten Eingang (IN1) und dem Ausgang (OUT) angeordnet ist,
**dadurch gekennzeichnet, dass** die Standby-Schaltung (4) eine Schaltung nach einem der Ansprüche 1 bis 9 ist.

11. Gerät nach Anspruch 10,
wobei der Mikrocontroller (8) mit dem dritten Eingang (IN2) in einer derartigen Weise verbunden ist, dass er den dritten Eingang (IN2) erden wird, wenn das elektrische Gerät in den Standby-Zustand zu versetzen ist.

12. Gerät nach Anspruch 11,
ferner umfassend ein Benutzerschnittstellenpaneel, umfassend wenigstens einen Knopf (7, 70), welcher von einem Nutzer des elektrischen Geräts betätigt werden kann, wobei der Knopf mit dem zweiten Eingang (IN3) der Standby-Schaltung (4) verbunden ist, so dass durch Drücken des Knopfs ein Signal erzeugt wird, welches den zweiten Eingang (IN3) erdet.

13. Gerät nach Anspruch 12,
wobei der Knopf ein Berührungsknopf ist und wobei ein Mikrocontroller (11) detektiert, wenn der Berührungsknopf gedrückt wird, und das Signal, welches dazu eingerichtet ist, den zweiten Standby-Eingang zu erden, erzeugt.

14. Gerät nach Anspruch 12,
wobei das Benutzerschnittstellenpaneel eine zweite Standby-Schaltung (400) umfasst, umfassend einen ersten Eingang (IN1), welcher mit einem Ausgang der Leistungszufuhr verbunden ist, um eine Gleichspannung zu empfangen, einen Ausgang (OUT), welcher mit einer zweiten Zufuhrleitung (RTN_D) verbunden ist, um eine Leistung an einen zweiten Mikrocontroller (8) zuzuführen, wobei die zweite Standby-Schaltung (4) eine Schaltung nach einem der Ansprüche 1 bis 9 ist.

15. Gerät nach Anspruch 14,
wobei der Knopf (7, 70) ein Berührungsknopf ist.

## Revendications

1. Circuit électrique de veille (4) destiné à un appareil électrique, comprenant :
un commutateur (41) conçu pour ouvrir et fermer une connexion électrique entre une première entrée (IN1) et une sortie (OUT) dudit circuit (4),
un circuit bistable connecté électriquement au dit commutateur pour commander l'ouverture et la fermeture dudit commutateur,
**caractérisé en ce que** ledit circuit bistable comprend un premier transistor BJT (Q19), et
un deuxième transistor BJT (Q12),
l'émetteur du premier transistor (Q19) étant connecté à ladite première entrée (IN1), et
le collecteur dudit premier transistor (Q19) étant connecté à la base du second transistor (Q12) à travers une première résistance (R39), et
le collecteur du deuxième transistor (Q12) étant connecté au dit commutateur (2) et à une seconde entrée (IN3) à travers une deuxième résistance (R40), et
la base du premier transistor (Q19) étant connectée à ladite seconde entrée (IN3) à travers une troisième résistance (R38).

2. Circuit selon la revendication 1, dans lequel ledit commutateur est un troisième transistor (41) et dans lequel le collecteur dudit deuxième transistor (Q12) est connecté à une borne dudit troisième transistor.

3. Circuit selon la revendication 2, dans lequel ledit troisième transistor (41) est un MOSFET transistor MOS (à effet de champ) (41), le drain du MOSFET (41) étant connecté à ladite sortie, la source du MOSFET (41) étant connectée à ladite première entrée et la grille du MOSFET (41) étant connectée au collecteur dudit deuxième transistor (Q12).

4. Circuit selon la revendication 3, comprenant de plus une résistance (R42) agencée en parallèle avec la jonction drain-source dudit MOSFET (41).

5. Circuit selon l'une quelconque des revendications précédentes, comprenant de plus au moins une résistance (R41, R34) agencée en parallèle avec l'une des jonctions base-émetteur dudit premier et dudit deuxième transistors.

6. Circuit selon l'une quelconque des revendications précédentes, comportant de plus un condensateur (C6) connecté entre ladite deuxième entrée (IN3) et la terre du circuit.

7. Circuit selon l'une quelconque des revendications précédentes, comportant de plus une troisième entrée (IN2) connectée à la base dudit deuxième transistor (Q12) afin de recevoir un signal de veille destiné au dit appareil électrique.

8. Circuit selon l'une quelconque des revendications précédentes, comportant de plus une branche de contre-réaction entre la sortie (OUT) dudit circuit et le collecteur dudit premier transistor (Q19).

9. Circuit selon l'une quelconque des revendications précédentes, comportant de plus une diode (D3) dont l'anode est connectée à la sortie (OUT) dudit circuit et dont la cathode est connectée au collecteur dudit premier transistor (Q19) .

10. Appareil électrique comportant :
une alimentation électrique AC/DC (alternatif/continu) (3) adaptée pour être connectée à une ligne de tension alternative (L, N) et pour convertir ladite tension alternative en une tension continue (RTN_0),
un microcontrôleur (6) conçu pour transmettre une commande de veille,
un circuit de veille (4) comprenant une première entrée (IN1) connectée à ladite alimentation électrique pour recevoir ladite tension continue (RTN_0), une sortie (OUT) connectée à une ligne d'alimentation (RTN), et un commutateur (41) interposé entre ladite première entrée (IN1) et ladite sortie (OUT),
**caractérisé en ce que** ledit circuit de veille (4) est un circuit selon l'une quelconque des revendications 1 à 9.

11. Appareil selon la revendication 10, dans lequel ledit microcontrôleur (8) est connecté à ladite troisième entrée (IN2) d'une manière telle qu'il mettra à la terre ladite troisième entrée (IN2) lorsque ledit appareil électrique doit être placé dans l'état de veille.

12. Appareil selon la revendication 11, comprenant de plus une carte d'interface pour utilisateur comprenant au moins un bouton (7, 70) pouvant être actionné par un utilisateur dudit appareil électrique, ledit bouton étant connecté à ladite deuxième entrée (IN3) dudit circuit de veille (4) de sorte qu'en appuyant sur ledit bouton un signal est généré, lequel met à la terre ladite deuxième entrée (IN3).

13. Appareil selon la revendication 12, dans lequel ledit bouton est un bouton à touche, et dans lequel un microcontrôleur (11) détecte quand ledit bouton à touche est pressé et génère ledit signal conçu pour mettre à la terre ladite deuxième entrée de veille.

14. Appareil selon la revendication 12, dans lequel la carte d'interface pour l'utilisateur comporte un deuxième circuit de veille (400) comportant une première entrée (IN1) connectée à une sortie de ladite alimentation électrique pour recevoir une tension continue, une sortie (OUT) connectée à une seconde ligne d'alimentation (RTN_D) pour fournir de l'électricité à un second microcontrôleur (8), ledit second circuit de veille (4) étant un circuit selon l'une quelconque des revendications 1 à 9.

15. Appareil selon la revendication 14, dans lequel ledit bouton (7, 70) est un bouton à touche.
